# EUROPEAN PATENT APPLICATION

(11) **EP 4 474 082 A1**
(43) Date of publication of application: **11.12.2024**
(21) Application number: 23382539.7
(22) Date of filing: 05.06.2023
(51) Int. Cl.: B22F 10/25, B22F 10/366, B22F 10/85, B23K 26/342, B33Y 50/02, B22F 10/80, B33Y 50/00, G06T 17/00, G06T 17/30, B22F 7/06, B22F 7/08, G06F 30/17, B23K 9/04

(54) **A METHOD AND SYSTEM FOR DETERMINING MULTI-LAYER TRAJECTORIES FOR LASER METAL DEPOSITION**

(71) Applicant: Talens Systems, S.L.U., 20870 Elgoibar - Gipuzkoa (ES); Fundacion Centro de Tecnologias de Interaccion Visual y comunicaciones Vicomtech, 20009 San Sebastian (ES)
(72) Inventor: Ortiz, Igor, ELGOIBAR, GIPUZKOA (ES); Álvarez, Piera, ELGOIBAR, GIPUZKOA (ES); Gabilondo, Jose Juan, ELGOIBAR, GIPUZKOA (ES); Moreno, Aitor, San Sebastian, GIPUZKOA (ES); Posada, Jorge, San Sebastian, GIPUZKOA (ES); Arbelaiz, Ander, San Sebastian, GIPUZKOA (ES); Creus, Carles, San Sebastian, GIPUZKOA (ES); Pareja-Corcho, Juan, San Sebastian, GIPUZKOA (ES); Ruiz-Salguero, Óscar, San Sebastian, GIPUZKOA (ES)
(74) Representative: Balder IP Law, S.L.

(57) **Abstract**

A computer implemented method and system for obtaining trajectories for laser metal deposition. The method comprises providing, to a controller, a mesh (M) representing a surface of a workpiece on which the laser metal deposition is to be carried out, the surface of the workpiece being delimited with a boundary (∂M). Then, the controller generates an isosurface of the surface from the mesh (M), the isosurface being an offset mesh (M_{offset}) that represents the surface of the piece, being unbounded and having a predefined offset (d) relative to the surface of the piece. After that, the controller traces the boundary (∂M) of the surface of the workpiece onto the isosurface to bound the isosurface and calculates the trajectories for laser metal deposition onto the bounded isosurface.

## Description

### FIELD OF THE INVENTION

The present invention generally refers to additive manufacturing techniques, such as additive layering manufacturing processes that use powders or wires to form a build or coat surfaces of pieces. More particularly, the present invention refers to methods and systems for determining trajectories for laser metal deposition on multiple layers, and methods for depositing material on the surface of a workpiece using the previously obtained trajectories.

### BACKGROUND OF THE INVENTION

Laser Metal Deposition (LMD) techniques refer to additive manufacturing processes that consist in the addition of material (powder or wire) to the surface of a finished part. Heated by a laser beam, the material melts and solidifies on the surface. The deposited layer strengthens the surface of the piece. These techniques, that allow depositing a plurality of layers, one of top of the other, on the surface of the piece, are widely used in aerospace, chemical and automobile industries, and in general, in any machinery subjected to a high temperature and/or high wear operation environment.

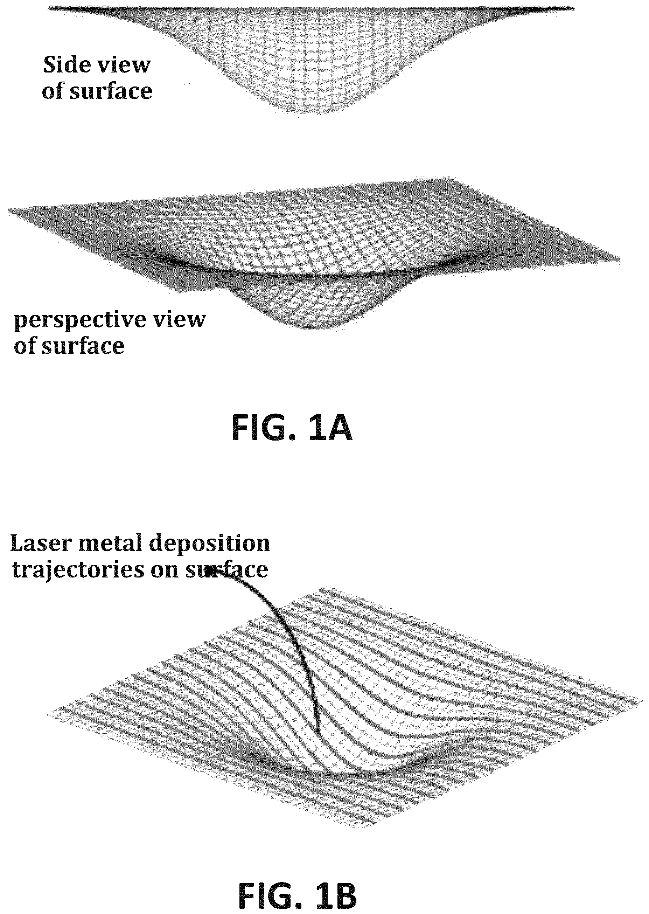

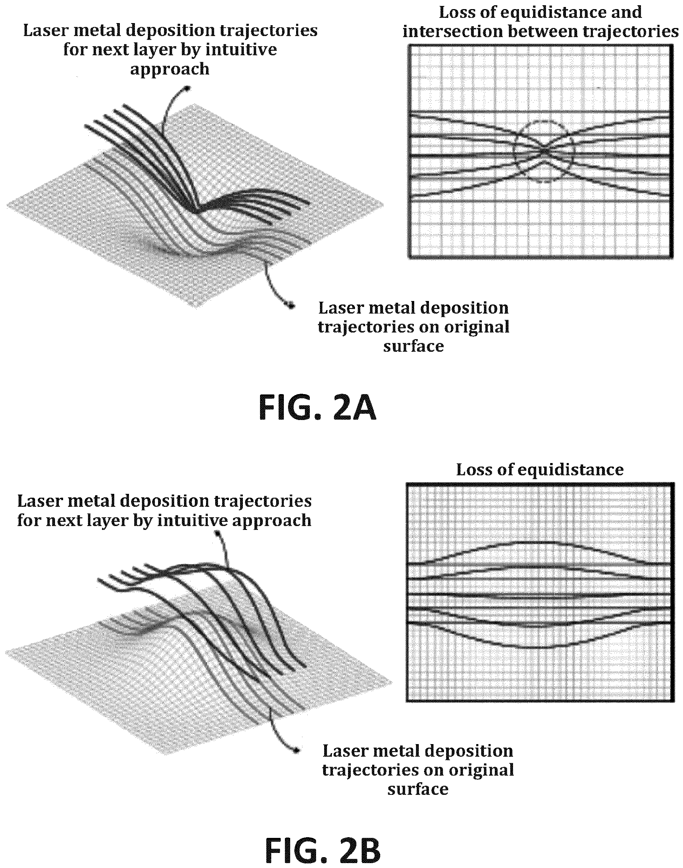

The computational geometry support for planning the LMD process involves a valid geometric representation of the target connected subset of a surface with 2-manifold properties, hereinafter named as FACE, and the definition of material delivery trajectories on the target FACE (see Figure 1A that shows a side view and a perspective view of a target surface for the LMD process). The material delivery trajectories are parallel equidistant polylines that define the trajectory that the material delivery tool and the laser beam will follow through the LMD process (see Figure 1B showing the target surface of Figure 1A with the delivery trajectories projected on it). The equidistance between the lines in a set of trajectories must be guaranteed every time to ensure the correct deposition of the material and avoid unwanted superposition of material. In LMD processes that require depositing several layers of material, a set of trajectories must be defined for every desired layer. The simple and straightforward solution of repeating the same trajectories as the initial layer and increasing the distance between the delivery tool and the surface of the piece for every layer entails several problems. Even in a simple surface such as the one shown in Figure 2 (Figure 2A shows a perspective exploded view and a top view of a concave target surface with two layers of material being deposited on it and Figure 2B shows a perspective exploded view and a top view of a convex target surface with two layers of material being deposited on it), following the solution presented before generates the loss of equidistance between the trajectories. In convex regions of the surface, as layer upon layer are being deposited, the trajectory lines move away from each other in the subsequent layers increasing the distance between them. This will create microgrooves between the deposited material of contiguous trajectories. On the contrary, in concave regions of the surface, as layer upon layer are being deposited, the trajectory lines move towards each other reducing the distance between them in the subsequent layers. This will create heaps between the deposited material of contiguous trajectories. Figure 2A also shows that it is also possible to have laser trajectories that intersect each other in the next layers when the aforementioned solution is used. In all these cases, the resulting coated surface may not comply with the precision and quality requirements of the industry.

To avoid this problem, a valid representation of the target surface (FACE) is required for each one of the layers 'i', 'i+1', 'i+2' (wherein 'i' in an integer >0), and so on, resulting from the physical deposition iterations. This FACE representation will be used for the synthesis of the new set of laser trajectories without depending on the trajectories of the previous layer. Each valid FACE is an offset version of the previous one. The parametric space of the offset FACE is then required for the synthesis of the new set of laser trajectories. Direct computation of valid offset FACEs in parametric space entails the simultaneous solution of polynomial sets, a problem that exhibits high complexity. Therefore, indirect methods of computation applied on discrete representations of the surface (e.g., triangulations) are an alternative. As a response to this limitation, the solution herein disclosed presents the implementation of a mesh-based method to compute the offset of a surface or FACE (i.e., surface with border) with manifold properties.

Several existing solutions address the problem of laser metal deposition path generation on free form surfaces. The most common solution is to calculate the trajectories as the intersection between the free form surface and a set of parallel equidistant planes. Most solutions propose strategies to generate trajectories that improve the smoothness of the deposition layer or the efficiency of powder use. Some other solutions address the problem of ensuring the parallelism of the set of trajectories and reducing the amount of intersection calculations necessary. However, these solutions do not address the generation of a set of trajectories for a multi-layer coating process. Mesh offsetting methodologies usually fall under two categories: i) explicit surface methods and ii) implicit surface methods.

Explicit surface methods: these approximations explicitly compute the offset surface by the translation of every vertex in the mesh towards the direction of the local normal vector. The resulting mesh requires resolving the self-intersections introduced by the translation. The gaps between the translated faces are then filled with a blending mesh. If the input mesh is completely convex, the normal vector approach is fast and effective. The main advantages of these methods are: i) low computational cost and ii) accurate results for convex geometries. The main disadvantage of these methods is that they introduce self-intersections in the resulting mesh. The detection and healing of these self-intersections is a time consuming and challenging task.

Implicit surface methods: these approximations calculate the offset mesh as the implicit surface `f(x, y, z) = d', where 'd' is the desired distance to the original mesh. This approach requires the calculation of distance field on a volumetric grid that envelops the original mesh. The accuracy of these approaches is good enough for visualization, but they do not provide a usable manifold offset surface. The main advantages of volumetric approaches are: i) the resultant mesh is free of self-intersections and ii) it produces valid results for complex geometries composed of convex and concave regions. The main disadvantages of these methods are: i) the high computational cost in the computation of the distance field and ii) limited to closed surfaces (2-manifolds with no border).

Thus, existing solutions on the area of trajectory generation for laser metal deposition do not explicitly address the generation of a set of trajectories for a multi-layer coating processes. In the context of mesh offset generation, two types of approaches are most common: i) explicit surface approaches and ii) implicit surface approaches. Implicit surface approaches suffer from the setback of producing non-manifold regions (self-intersections) that render unusable the resulting offset mesh for laser trajectory calculation. Explicit surface approaches do not produce self-intersections but are currently restricted to manifolds without border (closed surfaces).

Hence, there is a need in the state of the art for method and systems which can generate a set of trajectories for multi-layer laser metal deposition processes in a very accurate manner and that are also able of overcome the aforementioned drawbacks.

### DESCRIPTION OF THE INVENTION

A first object of the invention is a computer implemented method for obtaining multi-layer trajectories for laser metal deposition. As used herein, laser metal deposition may refer to technologies that use a laser beam that creates a molten pool at the workpiece surface, to which is added the coating material (wire or powder) molten by the laser. Laser metal deposition is realized either as wire or powder. The exposure time is generally short, which creates only a short delay as the cooling is quick, resulting in a layer that is connected with the basic material metallurgically.

The method comprises providing, to a controller, a mesh (M) representing a surface of a workpiece on which at least two layers of material is to be deposited, the surface of the piece being delimited with a boundary (∂M). This mesh (M) represents the surface of the workpiece as a set of finite elements, preferably triangles although other finite elements with a different shape could be used. The mesh (M) may have been obtained by any well-known 3D modelling technique, such as ruled surface techniques, surface of revolution techniques and sculptured surface techniques, among many other techniques. Depositing multiple layers of material onto the surface of the workpiece in the direction of Z-axis, i.e., in height, implies depositing a first layer of material onto the surface at height zero and depositing at least one additional layer of material onto said first layer. Additional layers will be deposited onto the respective immediately preceding layer. The method herein disclosed in focused on the deposition of the second and subsequent layers of material, i.e., the offseted layers, being these offseted layers those defined by a predefined distance (d) in the deposition direction with respect to the original surface that is greater than zero.

Then, the controller generates an isosurface of the surface from the mesh (M), the isosurface being an offset mesh (M_{offset}) that represents the surface of the piece. This offset mesh (M_{offset}) has a predefined offset relative to the surface of the workpiece. Generally, the offset mesh (M_{offset}) has boundaries that exceed the limits of the boundaries of the original surface from which the mesh (M) has been obtained. The obtained isosurface is free from self-intersections.

After that, the controller traces, by projecting it, the boundary (∂M) of the surface of the workpiece onto the isosurface to bound the isosurface and calculates the trajectories for laser metal deposition onto the bounded isosurface. The magnitude of the predefined offset with respect to the thickness of the layers being deposited onto the surface of the workpiece determine the particular deposition layer the isosurface will represent. In other words, the predefined offset used to generate the isosurface will determine the particular layer (i,i+1,... ,i+n) of material to be deposited on the workpiece that the isosurface represents. For example, when each layer of deposited material has a thickness of 1 mm and the predefined offset is 1 mm the isosurface generated and the trajectories generated on it will correspond to the trajectories for the second layer of material to be deposited on the surface of the workpiece. When the predefined offset is 4mm the isosurface generated will correspond to the surface of the workpiece on which the trajectories of the fifth layer are to be generated, and so on.

The higher the resolution selected for the generation of the mesh (M), the better the quality and definition of the isosurface obtained. However, higher resolutions will also imply higher computational costs. Therefore, a compromise between the resolution of the mesh (M) and the associated computational cost for obtaining said isosurface should be found for each particular case.

As used herein, the term controller may refer to any combination of hardware and programming to implement the functionalities of the controller described herein. The controller may use the process logic used to control access to shared memory locations, or at a higher level to shared variables in the presence of multiple threads or processors. In examples described herein, such combinations of hardware and programming may be implemented in a number of different ways. For example, the programming for controller may be processor executable instructions stored on at least one non-transitory machine-readable storage medium and the hardware for controller may include at least one processor to execute those instructions. In some examples, at least one machine-readable storage medium may store instructions that, when executed by the at least one processing resource, at least partially implement the controller. In some examples, the functionalities of controller may be at least partially implemented in the form of electronic circuitry.

In some embodiments, the step of generating the offset isosurface of the workpiece comprises defining a vector field (*̅n̅*̅) normal to the mesh (M) pointing in a direction of the desired offset and immersing the mesh (M) into a regular orthogonal grid (G). Then, for each node (g) of the regular orthogonal grid (G), a minimal distance of the node (g) to the mesh (M) is determined as a function 'f(g) = mindistance (g,M)' and the sign of said function f(g) is determined based on the direction of the normal vector field (*̅n̅*̅). The dimensions of the regular orthogonal grid (G) have to be such that the mesh can be contained inside it. The higher the resolution selected for the generation of the regular orthogonal grid (G), the better the quality and definition of the offset isosurface obtained. However, higher resolutions will also imply higher computational costs. Therefore, a compromise between the resolution of the regular orthogonal grid (G) and the associated computational cost for obtaining said offset isosurface should be found for each particular case.

After, the offset mesh (M_{offset}) is calculated by applying a Marching Cubes (MC) algorithm using the function f(g) and an offset parameter corresponding to a desired offset distance (d). The MC algorithm is a computer graphics algorithm able to extract a polygonal mesh of an isosurface from a three-dimensional discrete scalar field (the elements of which are sometimes called voxels).

In some embodiments, defining the vector field (*̅n̅*̅) normal to the mesh (M) comprises associating one vector normal to each node of the mesh (M) pointing in the direction of the desired offset. The direction of the desired offset will coincide with the direction in which the material layers are to be deposited, generally in Z-axis direction.

In some embodiments, determining the sign of the function f(g) according to the direction of the normal vector field (*̅n̅*̅) comprises determining that the minimal distance of the node (g) to the mesh (M) is: positive when the node (g) is in one of the two portions of the grid (G) defined by the mesh (M), said one portion being the one towards which the vector field (*̅n̅*̅) points, and negative when the node (g) is in the other of the two portions of the grid (G) defined by the mesh (M). For example, the dot product of the vector that joins a particular node of the mesh (M) with a particular node (g) of the grid (G) with the normal vector (*̅n̅*̅) to that particular node of the mesh (M) could be calculated. Then, all the nodes (g) of the grid (G) whose dot product is positive will be located in one of the two spaces in which the grid (G) is divided by the mesh (M), in particular in the spaces corresponding to the surface of the workpiece on which the material is to be deposited, and the rest of nodes (g) of the grid (G) whose dot product is negative will be located in the other one of the two spaces of the grid (G).

In some embodiments, the step of generating the offset mesh (M_{offset}) comprises selecting, by the MC algorithm, those cells of the regular orthogonal grid (G) located at the desired offset distance (d) and in the direction defined by the normal vector field (*̅n̅*̅) from the mesh (M) and joining, by the MC algorithm, the selected cells forming the offset mesh (M_{offset}).

In some embodiments, the boundaries of the offset mesh (M_{offset}) correspond with the spatial limits of the regular orthogonal grid (G). That is to say, the Marching Cubes algorithm forces the boundaries of the offset mesh (M_{offset}) to coincide with the limits of the regular orthogonal grid (G).

In some embodiments, the step of tracing the boundary (∂M) of the surface of the workpiece onto the isosurface comprises:
projecting each point (P₁) of the boundary of the mesh (M) onto the offset mesh (M_{offset}) in the direction of its normal vector (*̅n̅*̅) in the mesh (M), such that a corresponding new point (P₂) on the offset mesh (M_{offset}) is determined;
joining the points (P₂) defining a polyline (∂M_{offset}) that forms an offset boundary on the offset mesh (M_{offset});
setting up a plane joining each pair of consecutive points (P₁) with their respective projected points (P₂), such that a set of planes is created;
detecting the intersection points (I) between the planes set up in the previous step and the offset mesh (M_{offset});
determining that a vertex of each triangle of the offset mesh (M_{offset}) intersected by the planes is a valid vertex when the vertex is inside the polyline (∂M_{offset});
deleting all intersected triangles from the offset mesh (M_{offset});
retriangulating the boundary region of the offset mesh (M_{offset}) using valid vertex and intersection points (I); and
selecting, by using a transitive closure algorithm, a part of the offset mesh (M_{offset}) contained within the retriangulated boundary (∂M_{offset}), obtaining the offset mesh (M_{offset}) with the boundary (∂M_{offset}), which is the projection of the boundary (∂M) of the surface of the workpiece, traced onto it.

In some embodiments, after tracing the boundary (∂M_{offset}) onto the isosurface, a portion of the offset mesh (M_{offset}) which is outside the retriangulated boundary (∂M_{offset}) is discarded.

In some embodiments, the method further comprises generating, by the controller, the mesh (M) representing the surface of the workpiece on which the laser metal deposition is to be carried out by using 3D models.

In some embodiments, the step of calculating the trajectories for laser metal deposition onto the bounded isosurface is carried out by using a Computer-Aided Manufacturing (CAM) software. This CAM software calculates the deposition path on the generated isosurface that will be followed by the nozzle of the laser metal deposition system being managed also by the CAM software. Examples of CAM software are PowerMILLO, Siemens NX^{®}, Fusion 360^{®}, etc. These CAM trajectories are generally transformed to a code, e.g., G-code, that can be read by the laser metal deposition systems. In some examples, the deposition path may be calculated for each bounded isosurface immediately after it has been generated and, once all the isosurfaces corresponding to all the layers to be deposited have been generated, said deposition paths could be joined forming a complete deposition path that is sent to the laser metal deposition system to start with the deposition procedure. In some other examples, once the deposition path for a particular isosurface has been generated it can be sent to the laser metal deposition system so the laser deposition process could be being carried out at the same time than other isosurfaces corresponding to upper layers are being calculated.

In some embodiments, the method for obtaining multi-layer trajectories for laser metal deposition described above is carried out for each layer of material to be deposited onto the surface of the workpiece. That is to say, the steps of generating the isosurface, tracing the boundary of the surface onto the isosurface and calculating the trajectories for laser metal deposition onto the bounded isosurface are carried out for each layer of material to be deposited onto the surface of the workpiece by varying the predefined offset used to generate the corresponding offset mesh (M_{offset}) and the respective isosurface obtained.

A second object of the invention is a computer program product comprising computer program instructions/code for performing the method previously disclosed.

A third object of the invention is a computer readable memory/medium that stores program instructions/code for performing the method previously disclosed.

A fourth object of the invention is a method for depositing material onto a surface of a workpiece. This method comprises the stages of:
providing the workpiece with at least one surface on which the material is to be deposited;
obtaining, by the controller, multi-layer trajectories for carrying out the laser metal deposition on the at least one surface of the workpiece by the method previously disclosed; and
depositing, by a laser metal deposition system, the material onto the at least one surface of the workpiece and according to the multi-layer trajectories obtained. The material can be selected from a group comprising metal wire, metal powder, ceramic wire, ceramic powder and any combination thereof.

A fifth object of the invention is a system for obtaining trajectories for laser metal deposition. The system comprises a receiving module configured to receive a mesh (M) representing a surface of a workpiece on which the laser metal deposition is to be carried out, the surface of the piece being delimited with a boundary(∂M); and a controller configured to:
generate an isosurface of the surface from the mesh (M), the isosurface being an offset mesh (M_{offset}) that represents the surface of the piece, the isosurface being unbounded and having a predefined offset (d) relative to the surface of the workpiece. The magnitude of the predefined offset (d) with respect to the thickness of the layers being deposited onto the surface of the workpiece determine the particular deposition layer the isosurface will represent;
trace the boundary (∂M) of the surface of the workpiece onto the isosurface to bound the isosurface; and
calculate the trajectories for laser metal deposition onto the bounded isosurface.

The solution herein disclosed is able to compute an implicit version of the offset mesh (M_{offset}), which is free from self-intersections, that is bounded with the boundary of the original mesh (M) that allows the use of well-known algorithms to generate multi-layer trajectories on said offset mesh (M_{offset}) for laser metal deposition on free form surfaces. This solution successfully, efficiently and accurately (1) computes an implicit version of the offset FACE, which is free from self-intersection, and (2) explicitly traces the original FACE boundary into the offset surface to bound the desired FACE. The treatment of the boundary of the original surface is an improvement from the current volumetric approaches to offset generation, which are generally restricted to closed surfaces (2-manifolds without border). The presented strategy also avoids the problem of self-intersections of the offset mesh (inherent to normal vector approaches) by extracting a valid isosurface from a signed distance field.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out.

The drawings comprise the following figures:
Figure 1A shows a side view and a perspective view of a target surface, represented by a mesh (M), for the laser metal deposition process. Figure 1B shows the target surface of Figure 1A with the laser metal deposition trajectories projected on it according to the state of the art.
Figure 2A shows a perspective exploded view and an upper view of a concave target surface with two consecutive layers of laser metal deposition trajectories being projected on it according to the state of the art. Figure 2B shows a perspective exploded view and an upper view of a convex target surface with two layers of laser metal deposition trajectories being projected on it, according to the state of the art.
Figure 3 shows a flow diagram of the method for perspective view of a base surface for a laser metal deposition process, according to an embodiment of the invention.
Figure 4 shows a flow diagram of the process for generating the offset mesh (M_{offset}), according to an embodiment of the invention.
Figure 5 shows a side view and a perspective view of a mesh (M) generated from a concave workpiece on which trajectories are going to be calculated to perform laser metal deposition, according to an embodiment of the invention.
Figure 6 shows the vector field (*̅n̅*̅) normal to the nodes of the mesh (M) of Figure 5 and pointing in the direction of the desired offset.
Figure 7 shows the regular orthogonal grid (G) with the mesh (M) of Figures 5 and 5 immersed therein.
Figure 8 shows the calculated signed scalar field f(g) on the regular orthogonal grid (G) of Figure 7.
Figure 9 shows the mesh (M) of Figure 5 and the resultant offset mesh (M_{offset}), i.e., its isosurface, generated by the Marching Cubes (MC) algorithm with the offset parameter (d). Figure 9A shows a perspective view of the mesh (M) and the resultant offset mesh (M_{offset}) with d=-0.5. Figure 9B shows two cut views of the mesh (M) and the resultant offset mesh (M_{offset}) with d=0.5 and d=-0.5, respectively.
Figure 10 shows a flow diagram of the process of tracing the boundary of the surface from which the mesh (M) of Figure 5 has been obtained onto the isosurface (offset mesh (M_{offset})).
Figure 11 shows the projection of boundary (∂M) of the mesh (M) of Figure 5 onto the offset mesh (M_{offset}).
Figure 12 shows the projection of an edge from the boundary (∂M) of the mesh (M) onto the offset mesh (M_{offset}), according to an embodiment of the invention.
Figure 13 shows a line-triangle approach for detecting intersection points (I) between an edge projection and the offset mesh (M_{offset}) on which said edge is projected.
Figure 14 shows how a cut plane between two consecutive points, h(Pᵢ) and h(Pᵢ₊₁), in set h(∂M) is defined, according to an embodiment of the invention.
Figure 15 shows the result of the calculation of intersection points (I), according to an embodiment of the invention.
Figure 16 shows a presentation of the areas on the offset mesh (M_{offset}) in the boundary area to be kept and discarded, according to an embodiment of the invention.
Figure 17 shows the vectors calculated for each intersection point to determine whether they are accepted or rejected, according to an embodiment of the invention.
Figure 18 shows a set of accepted vertices in in the boundary area of the offset mesh (M_{offset}), according to an embodiment of the invention.
Figure 19 shows a representation o the bounded isosurface and the area of the offset mesh (M_{offset}) after the transitive closure algorithm has been applied, according to an embodiment of the invention.

### DETAILED DESCRIPTION

The solution herein disclosed focus on the calculation of an isosurface, also named as offset mesh (M_{offset}), for each layer of a muti-layer laser metal deposition process that enables the use of well-known algorithms to generate deposition trajectories on said isosurfaces.

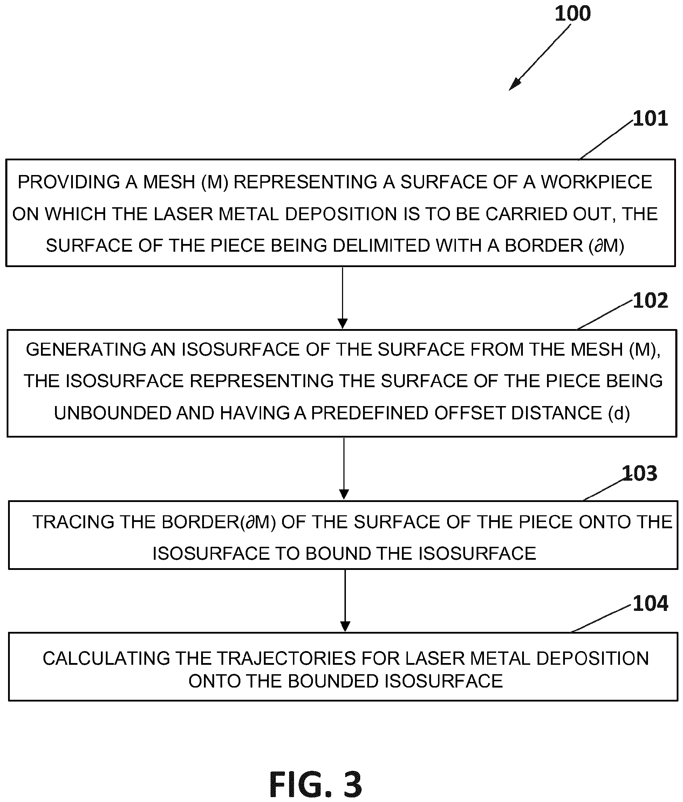

Figure 3 shows a flow diagram of the method (100) for perspective view of a base surface for a metal deposition process, according to an embodiment of the invention.

Firstly, a computer unit, such as a controller, receives (101) a mesh (M) that represents a surface of a workpiece on which the laser metal deposition is to be carried out. The surface of the workpiece is delimited with a boundary or border (∂M). This mesh (M) represents the surface of the workpiece as a set of finite elements, preferably triangles.

Then, the controller generates (102) an isosurface of the surface from the mesh (M), the isosurface being an offset mesh (M_{offset}) that represents the surface of the piece. This offset mesh (M_{offset}) has a predefined offset (d) relative to the original surface of the workpiece. The magnitude of the predefined offset (d) with respect to the thickness of the layers being deposited onto the surface of the workpiece will determine the particular layer the respective isosurface being generated is going to represent.

After that, the controller traces (103), by projecting it, the boundary (∂M) of the surface of the workpiece onto the generated isosurface to bound the isosurface and calculates (104) the trajectories for laser metal deposition onto the bounded isosurface. These trajectories can be calculated by any well-known process capable of calculating laser metal deposition trajectories onto 2D surfaces, such as conventional Computer Aided Manufacturing (CAM) techniques.

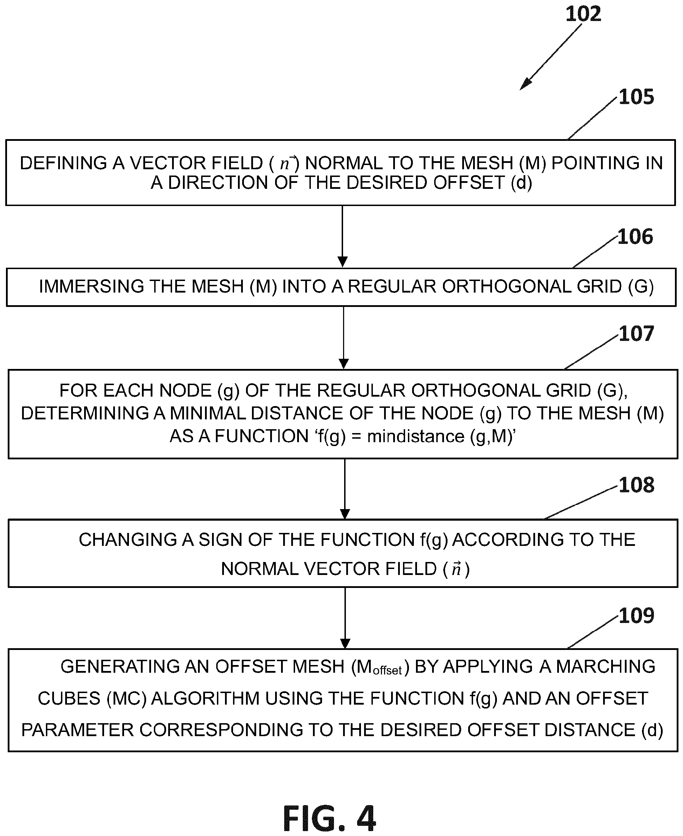

Figure 4 shows a flow diagram of the process for generating (102) the offset mesh (M_{offset}), according to an embodiment of the invention.

At step 105, a vector field (*̅n̅*̅) normal to the mesh (M) and pointing in a direction of the desired offset (d) is defined. That is to say, a normal vector (*̅n̅*̅) is associated to each node of the mesh (M), said normal vectors (*̅n̅*̅) pointing in the direction of the desired offset distance (d).

At step 106, the mesh (M) is immersed into a regular orthogonal grid (G). This regular orthogonal grid (G) will be dimensioned to be able to contain the mesh (M).

At step 107, for each node (g) of the grid (g∈G), the value of the minimal distance (f(g)) of said node (g) to the mesh (M) is calculated [f(g) = mindistance(g, M)].

At step 108, the sign of function f(g) for each node (g) is changed according to the normal vector field (*̅n̅*̅). To do so, the dot product of the vector that joins a particular node of the mesh (M) with a particular node (g) of the grid (G) with the normal vector (*̅n̅*̅) to that particular node of the mesh (M) could be calculated. Then, those nodes (g) of the grid (G) whose dot product is positive can be located in one of the two spaces in which the grid (G) is divided by the mesh (M), in particular in the spaces corresponding to the surface of the workpiece on which the material is to be deposited, and the rest of nodes (g) of the grid (G) whose dot product is negative can be located in the other one of the two spaces of the grid (G).

At step 109, a Marching Cubes (MC) algorithm is run using the scalar field f(g) and the parameter corresponding to the desired offset distance (d). This Marching Cubes algorithm will construct the offset mesh (M_{offset}= {p ∈ R3 | f(p) = d}. The boundaries of the resulting isosurface correspond with the spatial limits of the regular orthogonal grid (G).

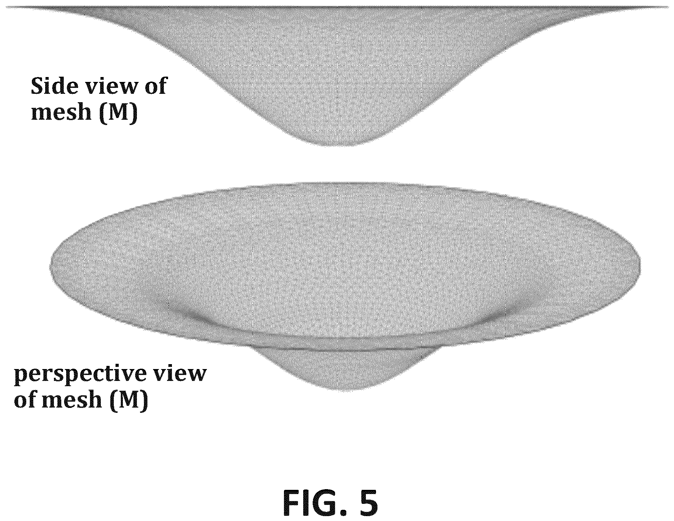

Figure 5 shows a side view and a perspective view of a mesh (M) generated from a concave workpiece on which trajectories are going to be calculated to perform laser metal deposition, according to an embodiment of the invention. In particular, the mesh (M) is a 3D view of the dataset representing the surface of interest of the concave workpiece.

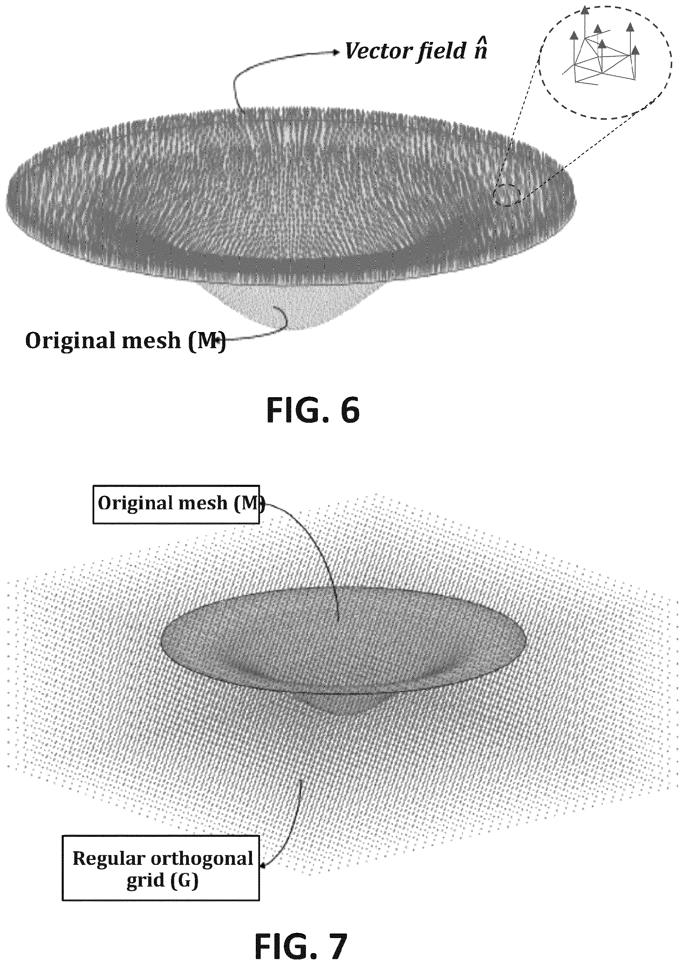

Figure 6 shows the vector field (*̅n̅*̅) normal to the nodes (g) of the mesh (M) of Figure 5 and pointing in the direction of the desired offset, i.e., in the direction of the layer deposition. In this particular embodiment, the vector field (*̅n̅*̅) points upwardly. The direction of the normal vectors in (*̅n̅*̅) will dictate the sign of the isosurface parameter (the sign of the scalar field 'f(g)') to be used in step 109 of the method for obtaining multi-layer trajectories for laser metal deposition. A positive isosurface parameter will construct the surface in the direction of the normal vectors. A negative isosurface parameter will construct the surface in the opposite direction of the normal vectors.

Figure 7 shows the regular orthogonal grid (G) with the mesh (M) of Figure 5 immersed therein. A higher resolution of the orthogonal grid (G) will result in a smoother offset mesh (M_{offset}) but will impose a significantly higher computational cost in the calculation of the signed distance field and the Marching Cubes algorithm. Thus, a compromise is to be reached between the resolution and computational cost when determining the resolution of the regular orthogonal grid (G). The resolution of the mesh (M) may also impact on the computational process of the method so, preferably, a compromise between its resolution and computational cost is to be reached too.

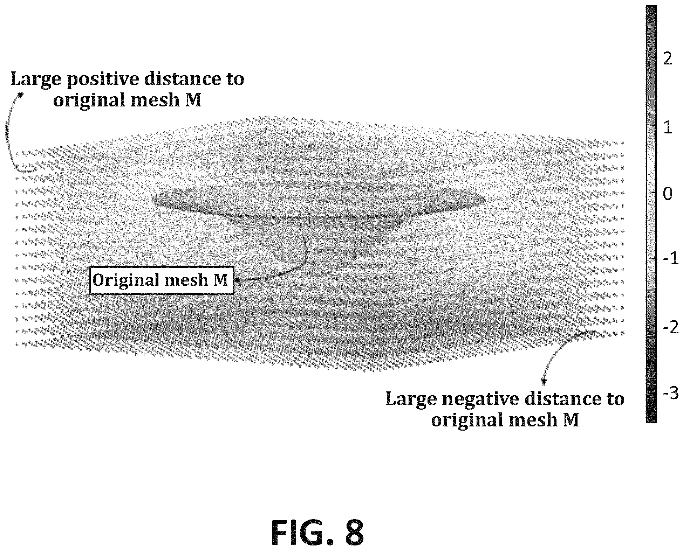

Figure 8 shows the calculated signed scalar field f(g) on the regular orthogonal grid (G) of Figure 7 with respect to the mesh (M). The signed scalar field f(g) should be completely partitioned by the mesh (M) such that there are two distinct regions of the scalar field: one with positive distances and one with negative distances. To achieve this, it is important to ensure the coherent orientation of all triangles in the mesh (M), i.e., that there is no defects in the meshing of the original surface. In this particular embodiment, those nodes (g) of the grid (G) located over (in the Z-axis direction) the plane defined by the mesh (M) and the projection of its border in the plane X-Y are considered to be positives. Thus, those nodes (g) of the grid (G) located below the plane defined by the mesh (M) and the projection of its border in the plane X-Y are considered to be positives.

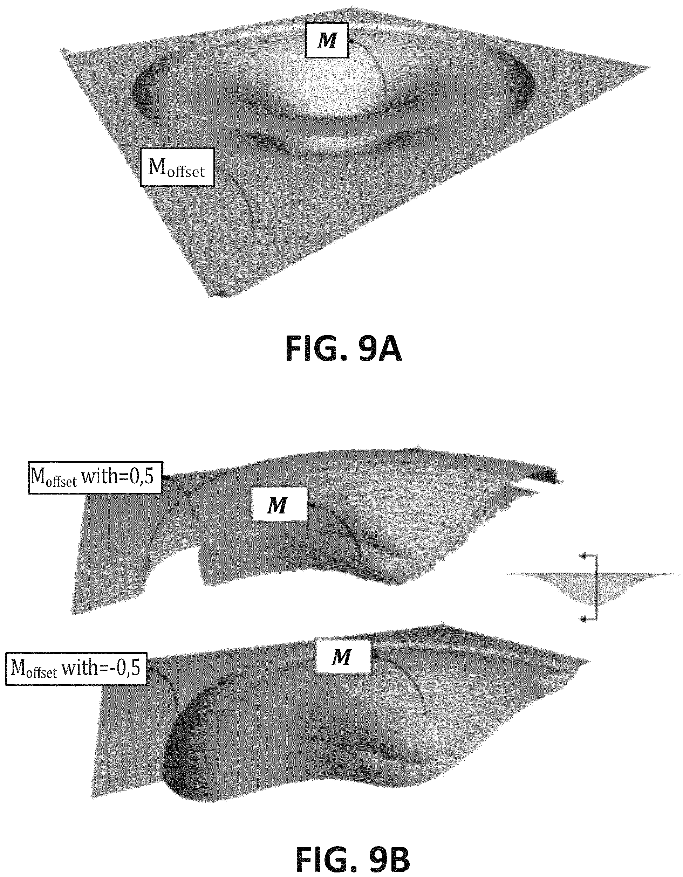

Figure 9 shows the mesh (M) of Figure 5 and the resultant offset mesh (M_{offset}), i.e., its isosurface, generated by the Marching Cubes (MC) algorithm with a particular offset parameter (d). Figure 9A shows a perspective view of the mesh (M) and the resultant offset mesh (M_{offset}) with the offset parameter d=-0.5. Figure 9B shows two cut views of the mesh (M) and the resultant offset mesh (M_{offset}) with the offset parameter d=0.5 and d=-0.5, respectively. The Marching Cubes algorithm forces the boundary (∂M_{offset}) of the offset mesh (M_{offset}) to coincide with the limits of the regular orthogonal grid (G). Therefore, it becomes necessary to bound the offset mesh (M_{offset}) by tracing the original boundary (∂M) from the mesh (M) into the offset mesh (M_{offset}). The offset mesh (M_{offset}) is 2-manifold.

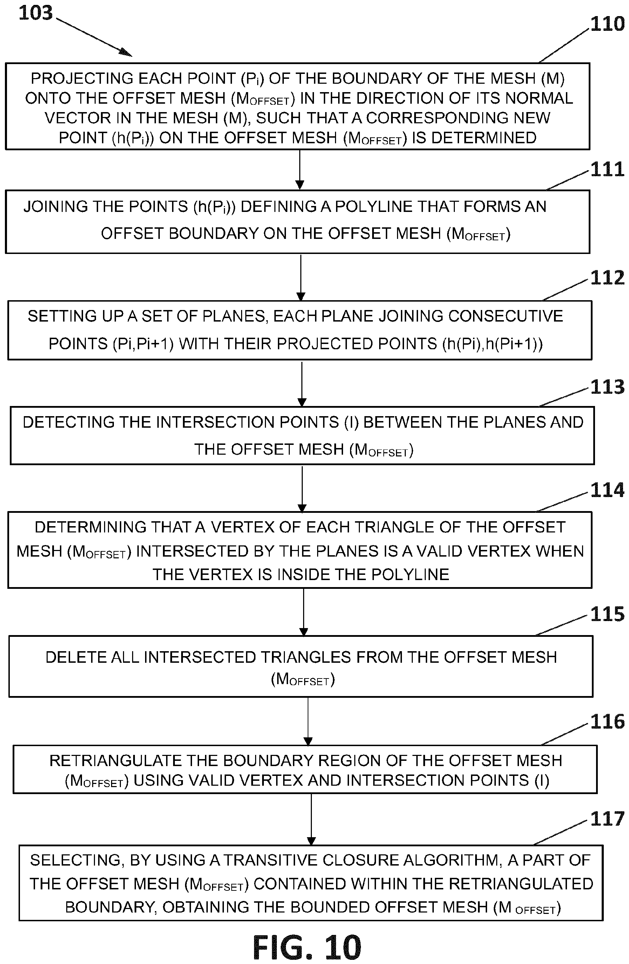

Figure 10 shows a flow diagram of the process (103) of tracing the boundary (∂M) of the surface of the workpiece from which the mesh (M) of Figure 4 has been obtained onto the isosurface (M_{offset}).

At step 110, each point (P∈∂M) is projected to the offset mesh (M_{offset}) according to the normal vector (*̅n̅*̅) in the mesh (M), such that a new point (h(P)∈M_{offset}) is determined.

At step 111, the ordered set of points (h(∂M)={h(P)∈∂M_{offset} | P∈∂M} is joined describing a polyline (∂M_{offset}) on the offset mesh (M_{offset}) that is the new desired boundary of the offset mesh (M_{offset}).

At step 112 a set of planes, wherein each plane joins a pair of consecutive points (Pᵢ) and (Pᵢ₊₁) in the mesh (M) and their corresponding projected points h(Pᵢ) and h(Pᵢ₊₁) in the offset mesh (M_{offset}), are set up.

At step 113, the intersection points (I) between the set of planes set up in the previous step and the finite elements forming the offset mesh (M_{offset}) are detected.

At step 114, the calculated intersection points (I) are used to decide on the validity of each vertex in the triangles of the offset mesh (M_{offset}) intersected by the planes. If a vertex of an intersected triangle is inside the polyline (∂M_{offset}) described by h(∂M), then it is considered valid. Otherwise, it is considered not valid.

At step 115, all the intersected triangles of the offset mesh (M_{offset}) are deleted.

At step 116, the boundary region of the offset mesh (M_{offset}) is retriangulated using only those valid vertices detected at step 114 and the intersection points (I). The resulting offset mesh (M_{offset}) is partitioned in two parts delimited by the boundary (∂M_{offset}).

At step 117, the part of the offset mesh (M_{offset}) containing the desired boundary (∂M_{offset}) is selected using a transitive closure algorithm obtaining the bounded offset mesh (M_{offset}), i.e., the bounded isosurface.

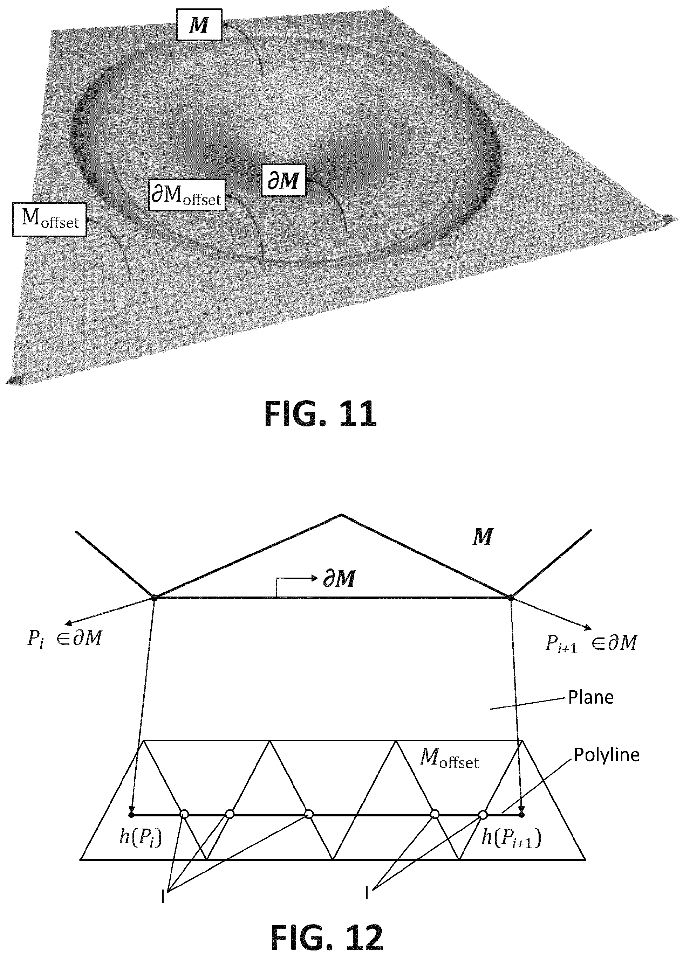

Figure 11 shows the projection (∂M_{offset}) of the boundary (∂M) of the mesh (M) of Figure 5 onto the offset mesh (M_{offset}).

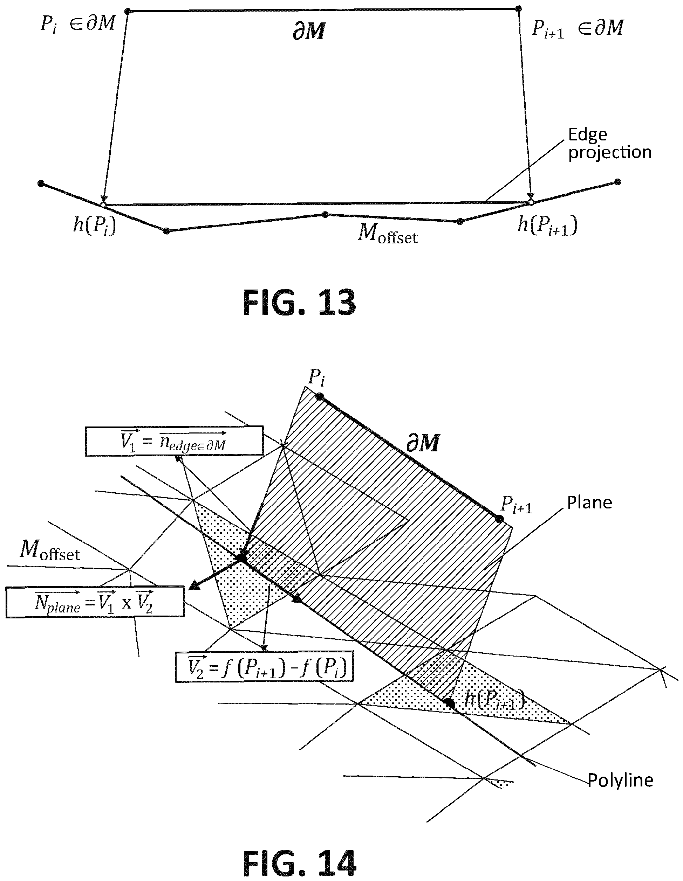

Figure 12 shows the scheme of the calculation of the intersection points (I), according to an embodiment of the invention. This calculation is explained at steps 110-113 of Figure 10. The projection of the boundary (∂M) of the mesh (M) onto the offset mesh (M_{offset}) results in a polyline (∂M_{offset}) traced on the offset mesh (M_{offset}) that is described by the ordered set h(∂M) = {h(P) ∈ M_{offset} | P ∈ ∂M}, where function h(P) is the orthogonal projection according to the normal vector of the mesh (M) at point P. The set h(∂M) should preferably preserve the order from the boundary (∂M) of the mesh (M). In this embodiment, a plane-triangle intersection is used to avoid the problems that arise when using line-triangle intersection, as shown in Figure 13.

Figure 13 shows the projection of an edge from the boundary (∂M) of the mesh (M) onto the offset mesh (M_{offset}), using a line-triangle intersection approach. Said figure 13 shows the problem with considering line-triangle intersection in detecting intersection points when the offset mesh (M_{offset}) does not present a planar structure. Given that the resolution of the offset mesh (M_{offset}) is usually considerably larger than the resolution of the original mesh (M), using a line-triangle intersection may not detect intersections in triangles that are on the boundary and should be clipped. It can be seen in figure 13 how said edge projection, obtained by joining the projected points h(Pᵢ) and h(Pᵢ₊₁) in the offset mesh (M_{offset}) and that forms the polyline (∂M_{offset}), does not intersect the whole offset mesh (M_{offset}) missing some potential intersection points (I) that may exist in the portion of the offset mesh (M_{offset}) between the projected points h(Pᵢ) and h(Pᵢ₊₁) .

Figure 14 shows how a cut plane between two consecutive points, h(Pᵢ) and h(Pᵢ₊₁), in set h(∂M) is defined. The plane is defined by a point h(Pᵢ) and a vector (*̅N̅ₚ̅ₗ̅ₐ̅ₙ̅ₑ̅*̅) normal to the plane, or a point and two vectors within the plane *̅V̅*̅₁̅ and *̅V̅*̅₂̅. Each triangle in the local neighborhood is intersected with the plane to obtain the intersection points between the triangle edges and the plane. The order of the projected boundary points h(∂M) ensures that the normal vector of the plane always points towards the outside of the desired boundary. In this particular embodiment, the direction of the vector (*̅N̅ₚ̅ₗ̅ₐ̅ₙ̅ₑ̅*̅) determines that the triangles located outside the bounded offset mesh (M_{offset}) are those contained in the portion of the offset mesh (M_{offset}) pointed by said vector (*̅N̅ₚ̅ₗ̅ₐ̅ₙ̅ₑ̅*̅)*.*

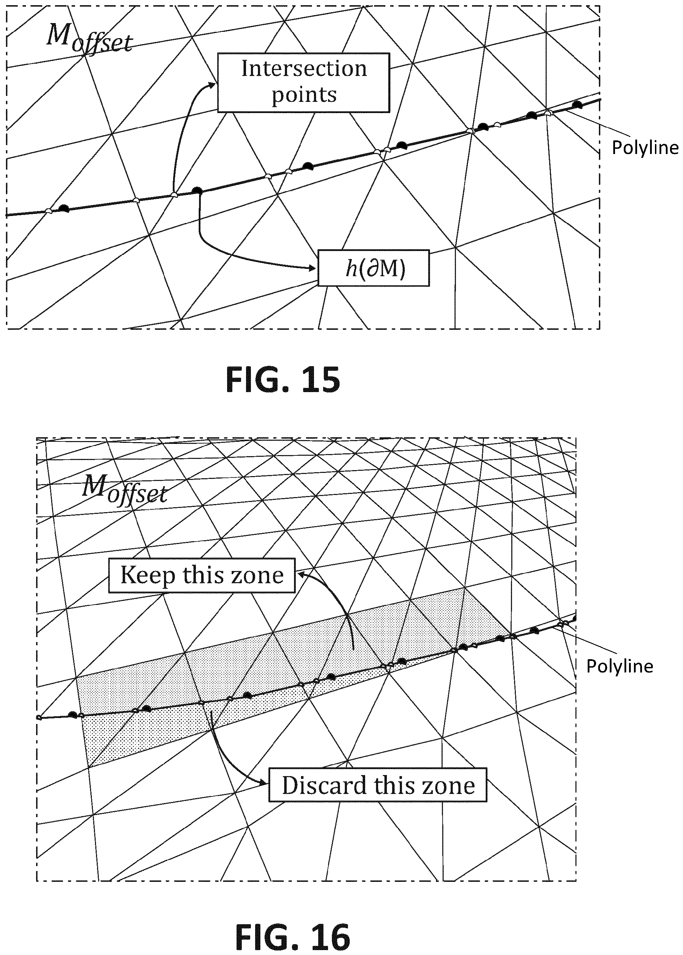

Figure 15 shows the result of the calculation of intersection points (I), according to an embodiment of the invention. The transitive closure algorithm also takes into account the degenerate cases of intersection, when intersection between plane and triangle is (a) a point, (b) coincides with an edge of the triangle or (c) is coplanar with the triangle itself.

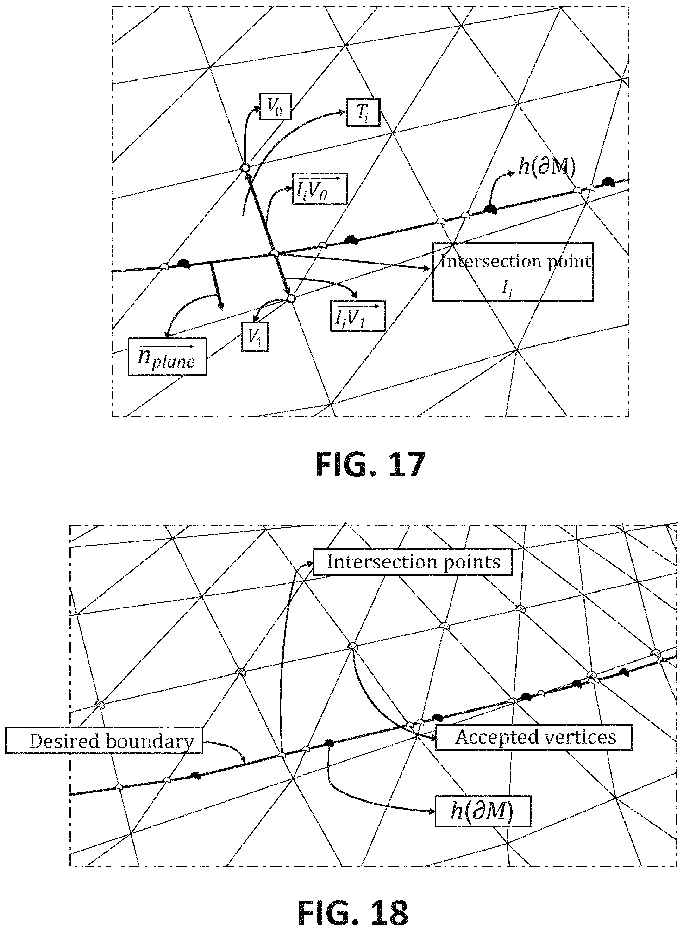

After intersection points (I) are calculated, each triangle is partitioned into two regions (see Figure 16). The region inside the desired boundary (∂M_{offset}) is to be preserved and retriangulated to obtain a new boundary region. The region outside the desired boundary (∂M_{offset}) is to be deleted from the boundary representation of the offset mesh (M_{offset}). To detect and retriangulate the region inside the desired boundary (∂M_{offset}), a test (see Figure 17) is performed to every vertex of every triangle intersected by the polyline (∂M_{offset}). A vector is drawn from an intersection point (Iᵢ) to each vertex (V₁) and (V₀) of the intersected edge of the triangle (Tᵢ). The direction of those vectors (*̅I̅ₗ̅V̅*̅₀̅) and (*̅I̅ₗ̅V̅*̅₁̅) is compared with the direction of the vector normal to the plane (*̅N̅ₚ̅ₗ̅ₐ̅ₙ̅ₑ̅*̅) (see Figure 14). If their dot product is negative (they oppose each other) or zero (they coincide) then the vertex is marked as accepted, otherwise it is rejected (V₁). In this particular embodiment, the vertex (V₀) is marked as accepted and vertex (V₁) is marked as rejected. This way of testing the acceptance of each vertex allows to easily handle the degenerate situations when the intersection point (I) coincides with a vertex.

Figure 18 shows the result of applying the acceptance test to each one of the vertices of the intersected triangles. The accepted vertex lies inside the desired boundary (∂M_{offset}) represented by the intersection points (I) and projected boundary points h(∂M). All the intersected triangles in the boundary region are then deleted from the offset mesh (M_{offset}). For each triangle intersected by the desired boundary (∂M_{offset}), the set of accepted vertices, intersection points and projected boundary points (if any) is retriangulated using, for example, a Delaunay constrained triangulation although other triangulation techniques could be used. The new triangles resulting from the retriangulation process are inserted into the boundary representation of the isosurface.

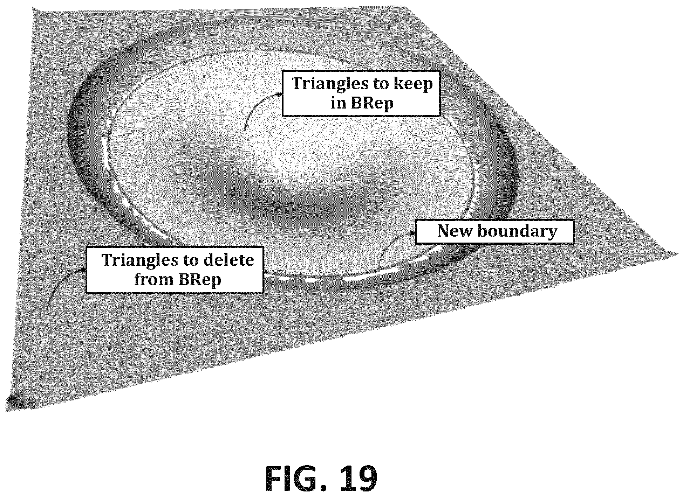

After the deletion and retriangulation of the boundary region, the offset mesh (M_{offset}) is partitioned into two regions. Figure 19 shows the partitioned offset mesh (M_{offset}). One of the regions is the bounded isosurface with the correct boundary (∂M_{offset}) traced from the original mesh (M). The region of the offset mesh (M_{offset}) outside of the boundary (∂M_{offset}) is to be deleted. Then, the deposition trajectories can be projected onto the obtained bounded isosurface.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the disclosure is obviously not limited to the specific embodiment(s) described herein, but also encompasses any variations that may be considered by any person skilled in the art (for example, as regards the choice of materials, dimensions, components, configuration, etc.), within the general scope of the disclosure as defined in the claims.

## Claims

1. A computer implemented method (100) for obtaining multi-layer trajectories for laser metal deposition, **characterized in that** the method comprises the steps of:
providing (101), to a controller, a mesh (M) representing a surface of a workpiece on which the laser metal deposition is to be carried out, the surface of the piece being delimited with a boundary (∂M);
generating (102), by the controller, an isosurface of the surface from the mesh (M), the isosurface being an offset mesh (M_{offset}) that represents the surface of the piece having a predefined offset relative to the surface of the piece, the predefined offset determining a particular layer on which trajectories for laser metal deposition are to be projected;
tracing (103), by the controller, the boundary of the surface of the workpiece onto the isosurface to bound the isosurface; and
calculating (104), by the controller, the trajectories for laser metal deposition onto the bounded isosurface.

2. The method according to claim 1, wherein the step of generating (102) the isosurface of the workpiece comprises:
defining (105) a vector field (*̅n̅*̅) normal to the mesh (M) pointing in a direction of the desired offset;
immersing (106) the mesh (M) into a regular orthogonal grid (G);
for each node (g) of the regular orthogonal grid (G), determining (107) a minimal distance of the node (g) to the mesh (M) as a function 'f(g) = mindistance (g,M)';
determining (108) a sign of the function f(g) according to the direction of normal vector field (*̅n̅*̅);
generating (109) the offset mesh (M_{offset}) by applying a Marching Cubes (MC) algorithm using the function f(g) and an offset distance (d) corresponding to the predefined offset.

3. The method according to claim 2, wherein defining the vector field (*̅n̅*̅) normal to the mesh (M) comprises associating one vector normal to each node of the mesh (M) pointing in the direction of the predefined offset.

4. The method according to claim 2 or 3, wherein determining the sign of the function f(g) according to the direction of the normal vector field (*̅n̅*̅) comprises determining that the minimal distance of the node (g) to the mesh (M) is:
positive when the node (g) is in one of the two portions of the grid (G) defined by the mesh (M), said one portion being the one towards which the vector field (*̅n̅*̅) points, and
negative when the node (g) is in the other of the two portions of the grid (G) defined by the mesh (M).

5. The method according to any one of claims 2 to 4, wherein generating the offset mesh (M_{offset}) comprises:
selecting, by the MC algorithm, those points of the regular orthogonal grid (G) located at the predefined offset distance (d) and in the direction defined by the normal vector field (*̅n̅*̅) from the mesh (M); and
joining, by the MC algorithm, the selected points forming the offset mesh (M_{offset}).

6. The method according to any one of claims 2 to 5, wherein the boundaries of the offset mesh (M_{offset}) correspond with the spatial limits of the regular orthogonal grid (G).

7. The method according to any one of the preceding claims, wherein the step of tracing the boundary of the surface of the workpiece onto the isosurface comprises:
projecting (110) each point (Pᵢ) of the boundary of the mesh (M) onto the offset mesh (M_{offset}) in the direction of its normal vector in the mesh (M), such that a corresponding new point (h(Pi)) on the offset mesh (M_{offset}) is determined;
joining (111) the points (h(Pᵢ)) defining a polyline (∂M_{offset}) that forms an offset boundary on the offset mesh (M_{offset});
setting up (112) a set of planes, each plane joining a pair of consecutive points (Pᵢ, Pᵢ₊₁) with their respective projected points (h(Pᵢ),h(Pᵢ₊₁));
detecting (113)the intersection points (I) between the planes and the offset mesh (M_{offset});
determining (114) that a vertex of each triangle of the offset mesh (M_{offset}) intersected by the planes is a valid vertex when the vertex is inside the polyline (∂M_{offset}),
deleting (115) all intersected triangles from the offset mesh (M_{offset});
retriangulating (116) the boundary region of the offset mesh (M_{offset}) using valid vertex and intersection points (I); and
selecting (117), by using a transitive closure algorithm, a part of the offset mesh (M_{offset}) contained within the retriangulated boundary, obtaining the offset mesh (M_{offset}) with the boundary of the surface of the workpiece onto the offset mesh (M_{offset}).

8. The method according to claim 7, wherein after tracing the boundary of the surface of the workpiece onto the isosurface, a portion of the offset mesh (M_{offset}) which is outside the retriangulated boundary (∂M_{offset}) is discarded.

9. The method according to any one of the preceding claims, comprising generating, by the controller, the mesh (M) representing the surface of the workpiece on which the laser metal deposition is to be carried out by using 3D models.

10. The method according to any one of the preceding claims, wherein the step of calculating the trajectories for laser metal deposition is carried out by computer aided model techniques.

11. The method according to any one of the preceding claims, wherein the steps of generating the isosurface, tracing the boundary of the surface onto the isosurface and calculating the trajectories for laser metal deposition onto the bounded isosurface are carried out for each layer of material to be deposited onto the surface of the workpiece.

12. A computer program product comprising computer program instructions/code for performing the method according to any one of claims 1 to 11.

13. A computer readable memory/medium that stores program instructions/code for performing the method according to any one of claims 1 to 11.

14. A method for depositing material onto a surface of a workpiece comprising:
providing the workpiece with at least one surface onto which the material is to be deposited;
obtaining, by the controller, multi-layer trajectories for carrying out the laser metal deposition on the at least one surface of the workpiece by the method according to any one of claims 1 to 10; and
depositing, by a laser meal deposition system, at least one layer of the material onto the at least one surface of the workpiece and according to the trajectories obtained, the material preferably being selected from a group comprising metal wire, metal powder, ceramic wire, ceramic powder and any combination thereof.

15. A system for obtaining trajectories for laser metal deposition, **characterized in that** the system comprises:
a receiving module configured to receive a mesh (M) representing a surface of a workpiece on which the laser metal deposition is to be carried out, the surface of the piece being delimited with a boundary (∂M); and
a controller configured to:
generate an isosurface of the surface from the mesh (M), the isosurface being an offset mesh (M_{offset}) that represents the surface of the piece having a predefined offset relative to the surface of the piece, the predefined offset determining a particular layer on which trajectories for laser metal deposition are to be projected;
trace the boundary of the surface of the workpiece onto the isosurface to bound the isosurface; and
calculate the trajectories for a particular layer of the laser metal deposition process onto the bounded isosurface.
